# EUROPEAN PATENT APPLICATION

(11) **EP 2 302 676 A1**
(43) Date of publication of application: **30.03.2011**
(21) Application number: 09171605.0
(22) Date of filing: 29.09.2009
(51) Int. Cl.: H01L 25/07, H01L 23/60

(54) **High power semiconductor device**

(71) Applicant: ABB Technology AG, 8050 Zürich (CH)
(72) Inventor: Hajas, David, CH-5630, Muri (CH)
(74) Representative: ABB Patent Attorneys

(57) **Abstract**

The invention is concerned with a high power semiconductor device comprising a substrate (10), a conductive layer (12) on a major surface of the substrate (10), a PD barrier (20) provided as a PD barrier layer along the edges of the conductive layer (12) where the conductive layer is joined to the substrate (10), wherein the PD barrier includes a ceramic material; and concerns a method for manufacturing such a high power semiconductor device.

## Description

### FIELD OF THE INVENTION

The invention relates to the field of high power semiconductor devices and methods of manufacturing such high power semiconductor devices.

### BACKGROUND OF THE INVENTION

High power semiconductor devices, for example, IGBT (insulated gate bipolar transistor) modules comprising IGBTs and free-wheeling diodes have operating voltages in the range of several thousand volts and operating currents in the range of more than a thousand amperes.

Such a high power semiconductor device typically comprises a substrate of aluminum nitride, for example, a conductive layer on a major surface of the substrate, and a PD (partial discharge) barrier provided as a PD barrier layer along the edges of the conductive layer where the conductive layer is joined to the substrate. At this location, i.e. where the conductive layer is joined to the substrate, peak electric fields of 10⁶ V/cm may be present. The PD barrier is employed for preventing the occurrence of partial discharges, and is conventionally made of PI (polyimide), a polymer with high dielectric strength.

Before semiconductor chips are connected by soldering to the conductive layer, it is common practice to mask certain areas of the conductive layer by providing solder stop areas which are applied as a polymer layer. The polymer used conventionally has a low surface energy, comparable to that of polytetrafluoroethylene, and is used to hinder the solder from wetting the substrate surface copper (Cu) around the chips and other soldered areas like, for example, pins. The solder stop area hinders the solder to wet the substrate; it passivates the surface, and hinders tin (Sn) contained in the solder to react with the copper, which is a driving force for the solder wetting during soldering.

Thin film silicon nitride is widely used in the microelectronics industry for passivation of semiconductor chip surfaces against corrosion and mechanical damage such as scratching. Silicon nitride may be deposited by plasma assisted or plasma enhanced chemical vapor deposition (PECVD) which enables the deposition of silicon nitride at temperatures as low as around 300°C, as described for example in S. M. SZE, "Semiconductor Devices", Physics and Technology", John Wiley & Sons (1985), ISBN O-471-87424.8, pp. 360-362.

### DESCRIPTION OF THE INVENTION

Despite the measures described above which were conventionally taken to prevent partial discharges from occuring in high power semiconductor devices it has turned out that still a considerable number of high power semiconductor devices are to be rejected due to PD. The most critical region where partial discharges are formed, is where the maximum electric field is localized, around the edges of the conductive layer where it meets the substrate; however, other sources for the generation of partial discharges may exist.

It is an objective of the invention to provide a high power semiconductor device which is less prone to the occurrence of partial discharges than conventional high power semiconductor devices. A further objective of the invention is providing a method of manufacturing such a high power semiconductor device.

These objectives are achieved by a device and a method, respectively, according to the independent claims. Preferred or advantageous embodiments of the invention are indicated in the dependent claims.

According to the invention as indicated in claim 1, the high power semiconductor device comprises a PD barrier which includes a ceramic material. Ceramic materials are known which possess a sufficiently high dielectric strength suitable for use as a PD barrier; moreover, ceramic materials may be applied, for example deposited, by techniques which are known, as such, in the microelectronics industry.

In a preferred variant of the invention, the high power semiconductor device further comprises at least one solder stop area provided as a solder stop layer on the conductive layer, wherein the solder stop area includes the same ceramic material as the PD barrier. It is assumed that polymer used conventionally as a solder stop may be degraded during heating (soldering) due to its relatively low thermal stability. Such a degraded solder stop is a potential PD source. By replacing it with a chemically stable material with low surface energy, i.e. by a suitable ceramic material, partial discharges may be diminished or prevented. Furthermore, such solder stop area which includes the same ceramic material as the PD barrier may be provided by the same technique with which the ceramic material of the PD barrier is provided, resulting in easier manufacturing.

According to an advantageous embodiment of the invention, the ceramic material comprises silicon nitride (SiN). The term "silicon nitride" (or SiN), as used herein, is intended to encompass crystalline stoichiometric (Si₃N₄) and non-stoichiometric forms of SiN as well as amorphous or hydrogenated forms (SiNₓ:H). Silicon nitride possesses a very high dielectric strength of approximately 10⁷ V/cm, approximately five times higher than that of polyimide which was conventionally used as the PD barrier. The silicon nitride is also used as a solder stop and hence replaces the conventionally used polymer solder stop. By replacing the conventionally used polymer by a chemically stable material with low surface energy, i.e. silicon nitride, partial discharges may be diminished or prevented.

According to further advantageous embodiments of the invention, the conductive layer comprises copper (Cu), silver (Ag), or gold (Au).

In a further advantageous embodiment of the invention, the edges of the conductive layer are joined with a substrate by a brazing protrusion bead, and the PD barrier covers the brazing protrusion bead. By providing a brazing protrusion bead a secure fixation of the conductive layer to the substrate may be achieved. This brazing protrusion bead is covered by the PD barrier for preventing or diminishing partial discharges.

According to a further advantageous embodiment of the invention, the high power semiconductor device further comprises a plurality of semiconductor chips, wherein each chip is provided on a respective area of the conductive layer surrounded by a continuous solder stop area. In this manner, a reliable connection by soldering of the semiconductor chips with certain areas of the conductive layer can be provided.

According to a further advantageous embodiment of the invention, the arrangement of the substrate, the conductive layer, the PD barrier, and solder stop areas is covered by a first coating layer which includes the same ceramic material as the PD barrier. This is basically a similar technique as that which is used in the semiconductor industry for chip passivation.

In order to further enhance the PD resistance, the first coating layer of the ceramic layer is covered by a second coating layer which includes polyimide (PI).

Similar considerations as outlined above apply in respect of the method according to the invention. As noted above, the ceramic material for the PD barrier and the solder stop area may be deposited by techniques which are known, as such, in the microelectronics industry.

In an advantageous embodiment of the inventive method, a plasma cleaning step is conducted before the step of providing the PD barrier and/or the solder stop area, and/or before covering by the first coating layer or by the second coating layer. A RF (radio frequency) plasma cleaning process may be employed. Plasma cleaning removes surface contaminants, particles, and activates the respective surfaces and thus increases the adhesion of a film of ceramic material.

### BRIEF DESCRIPTION OF THE DRAWINGS

The subject-matter of the invention will be explained in more detail in the hereinafter with reference to preferred exemplary embodiments which are illustrated in the attached drawings, in which:
Fig.1 schematically shows a cross section of a location at which a substrate and a conductive layer are joined by a brazing protrusion bead;
Fig.2 shows a top view and a cross section, respectively, of the substrate and a conductive layer;
Fig. 3 shows a top view and a cross section, respectively, of the substrate and a conductive layer, with a PD barrier and solder stop areas of a ceramic material;
   and
Fig. 4 schematically shows a high power semiconductor device (module) comprising a plurality of chips.

The reference symbols used in the drawings, and their meanings, are listed in summary form in the list of reference symbols. In principle, identical or similar parts are designated by the same or similar reference symbols in the figures. The figures are schematic and not necessarily to scale.

### DETAILED DESCRIPTION OF PREFERRED EMBODIMENTS

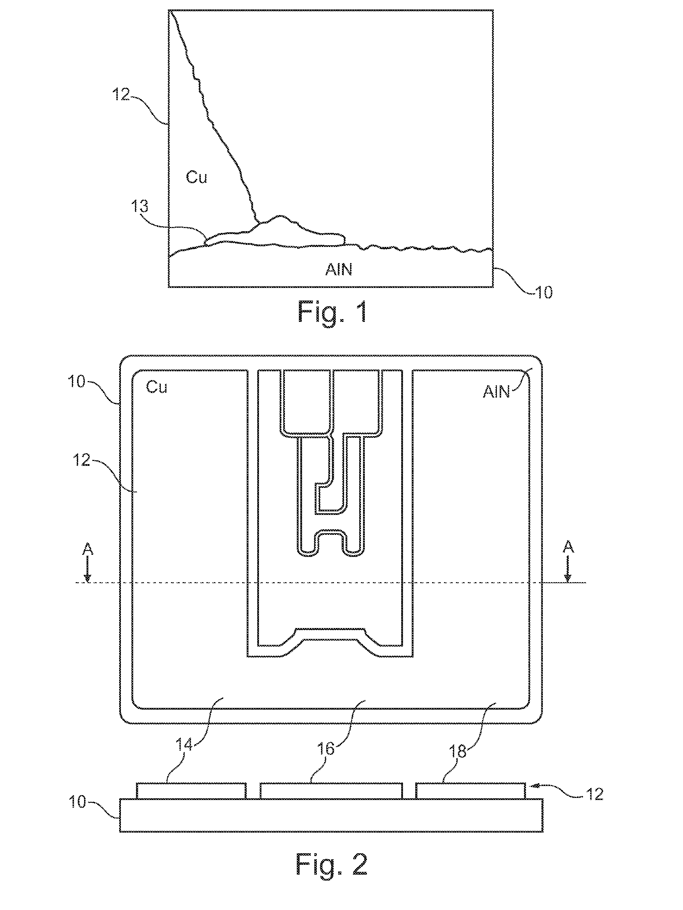

Fig.1 shows the cross section of an edge portion of a high power semiconductor device where the edge of a conductive layer 12 made of copper is joined to a substrate 10 made of aluminum nitride by a brazing protrusion bead 13. The edge of the conductive layer 12, and in particular the brazing protrusion bead 13, constitutes a region where high electric field strengths occur during operation of the high power semiconductor device. Therefore, this region, and in particular the brazing protrusion bead 13, will later be covered by a PD barrier provided as a PD barrier layer along the edges of the conductive layer 12.
Fig. 2 shows a top view and a cross section, respectively, in the direction of arrows A, of the substrate 10 and the conductive layer 12 provided thereon. The substrate 10 is made of aluminum nitride as mentioned above, and the conductive layer 10 is made of copper as mentioned above. The conductive layer 12 comprises three portions 14, 16, and 18.

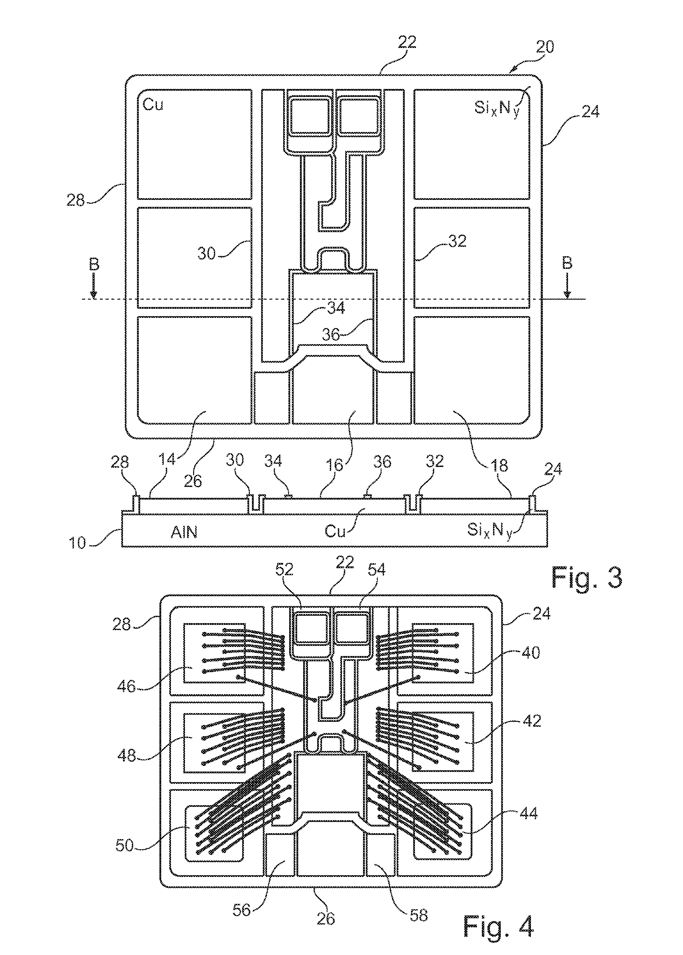

Fig. 3 shows a state in which, starting from the state shown in Fig. 2, a PD barrier 20 and solder stop areas 30, 32, 34, and 36 were deposited on the arrangement comprising the substrate 10 and the conductive layer 12. The PD barrier 20 as a PD barrier layer is provided along the four edges of the substrate 10, where the conductive layer 12 is joined to the substrate 10, and comprises an upper portion 22, a side portion 24, a lower portion 26, and another side portion 28 which are continuous with each other. The PD barrier 20 is formed of silicon nitride (SiₓN_{y}). Similarly, the solder stop areas 30, 32, 34, and 36 are made of silicon nitride.

The silicon nitride layers for the PD barrier and the solder stop areas 30, 32, 34, and 36 are deposited by plasma enhanced chemical vapor deposition (PECVD), and before deposition a mask is placed on the substrate, covering areas of the copper (Cu) metallization where chips, bond wires, pins, terminals, etc. were displaced and no silicon nitride should be deposited. Before deposition of the silicon nitride, a RF plasma cleaning process is performed which removes surface contaminants, particles, and activates the surfaces to be coated or covered, and thus increases the adhesion of the silicon nitride film. All edges of the conductive layer 12, as well as parts of the surface of the conductive layer 12 where solder stop areas are to be formed, are covered by depositing a silicon nitride film as shown in Fig. 3.

Fig. 3 shows additional areas (not designated by reference signs in Fig. 3) which are surrounded by solder stop areas, in particular those in which semiconductor chips 40, 42, 44, 46, 48, and 50 shown in Fig. 4 are to be located. Chip assembly follows according to standard processes conventionally used in the semiconductor or microelectronics industry.

Fig. 4 also shows gate control pins 52, 54 and terminal solder pads 56, 58 of the high power semiconductor device of Fig. 4.

Starting from the stage shown in Fig. 4, pins, terminal contacts, etc., are masked before a second silicon nitride film deposition is performed. Gate, emitter, and collector of the semiconductor chips 40 to 50 are short-circuited to guarantee that they are at the same potential.

Then the arrangement shown in Fig. 4 is plasma cleaned and coated with silicon nitride for providing a passivation of the surfaces of the high power semiconductor device of Fig. 4 against corrosion and mechanical damage.

After coating with silicon nitride, polyimide (PI) is deposited thereon as a layer, according to a standard process conventionally employed in the microelectronics or semiconductor industry.

The invention is not limited to the embodiments described above, and terms like "comprising" do not exclude other elements or steps, "a" or "an" do not exclude a plurality, and features recited in separate claims may be advantageously combined.

For example, another ceramic material instead of silicon nitride may be used as the ceramic material for the PD barrier and/or the solder stop area of the high power semiconductor device.

### LIST OF REFERENCE SYMBOLS

- 10: substrate
- 12: conductive layer
- 13: brazing protusion bead
- 14: portion of 12
- 16: portion of 12
- 18: portion of 12
- 20: PD barrier
- 22: upper portion of 20
- 24: upper portion of 20
- 26: lower portion of 20
- 28: side portion of 20
- 30: solder stop area
- 32: solder stop area
- 34: solder stop area
- 36: solder stop area
- 38: solder stop area
- 40: chip
- 42: chip
- 44: chip
- 46: chip
- 48: chip
- 50: chip
- 52: gate control pin
- 54: gate control pin
- 56: terminal solder pad
- 58: terminal solder pad

## Claims

1. A high power semiconductor device comprising:
a substrate (10);
a conductive layer (12) on a major surface of the substrate (10);
a PD barrier (20) provided as a PD barrier layer along the edges of the conductive layer (12) where the conductive layer is joined to the substrate (10);
wherein the PD barrier includes a ceramic material.

2. The high power semiconductor device of claim 1, further comprising at least one solder stop area (30; 32; 34; 36) provided as a solder stop layer on the conductive layer (12);
wherein the solder stop area includes the same ceramic material as the PD barrier (20).

3. The high power semiconductor device of claim 1 or 2, wherein the ceramic material comprises silicon nitride (SiN).

4. The high power semiconductor device of anyone of claims 1 to 3,
wherein
the conductive layer (12) comprises copper (Cu), silver (Ag) or gold (Au).

5. The high power semiconductor device of any one of claims 1 to 4, wherein the edges of the conductive layer (12) are joined with the substrate (10) by a brazing protrusion bead (13), and
the PD barrier covers the brazing protrusion bead.

6. The high power semiconductor device of any one of claims 2 to 5,
further comprising a plurality of semiconductor chips (40, 42, 44, 46, 48, 50), wherein each chip is provided on a respective area of the conductive layer (12) surrounded by a continuous solder stop area.

7. The high power semiconductor device of claim 6, wherein the arrangement of the substrate, the conductive layer, the PD barrier, and solder stop areas is covered by a first coating layer which includes the same ceramic material as the PD barrier.

8. The high power semiconductor device of claim 7, wherein the first coating layer of the ceramic layer is covered by a second coating layer which includes polyimide (PI).

9. A method of manufacturing a high power semiconductor device, comprising the steps of:
a) providing a substrate (10);
b.1) providing a conductive layer (12) on a major surface of the substrate,
and
b.2) joining the conductive layer to the substrate;
c.1) providing a PD barrier (20) as a PD barrier layer along the edges of the conductive layer (12) where the conductive layer is joined to the substrate (10);
c.2) wherein the PD barrier includes a ceramic material.

10. The method of claim 9, further comprising the step of:
d.1) providing at least one solder stop (30; 32; 34; 36) area as a solder stop layer on the conductive layer (12);
d.2) wherein the solder stop area includes the same ceramic material as the PD barrier.

11. The method of claim 9 or 10, wherein the ceramic material comprises silicon nitride (SiN).

12. The method of claim 10 or 11, further comprising the step of:
providing a plurality of semiconductor chips (40, 42, 44, 46, 48, 50) each arranged on a respective area of the conductive layer (12) surrounded by a continuous solder stop area.

13. The method of claim 12, further comprising the step of:
covering the arrangement of the substrate, the conductive layer, the PD barrier, and solder stop areas by a first coating layer which includes the same ceramic material as the PD barrier.

14. The method of claim 13, further comprising the step of:
covering the first coating layer of the ceramic material by a second coating layer which includes polyimide (PI).

15. The method of any one of claims 9 to 14, wherein the ceramic material is deposited on the conductive layer (12) by plasma enhanced chemical vapor deposition (PECVD).

16. The method according to any one of claims 9 to 15,
wherein a plasma cleaning step is conducted before the step of providing the PD barrier and/or the solder stop area, and/or before covering by the first coating layer or by the second coating layer.
